# DEMANDE DE BREVET EUROPEEN

(11) **EP 0 823 737 A1**
(43) Date de publication de la demande: **11.02.1998**
(21) Numéro de dépôt: 97401867.3
(22) Date de dépôt: 04.08.1997
(51) Int. Cl.: H01L 39/24, H01B 12/10, H01F 6/06, H01R 4/68

(54) **Brin Htc Multifilamentaire à disposition interne décalée**

(30) Priorité: 09.08.1996 FR 9610046
(71) Demandeur: ALCATEL ALSTHOM COMPAGNIE GENERALE D'ELECTRICITE, 75008 Paris (FR)
(72) Inventeur: Leriche, Albert, 91190 GIF sur Yvette (FR); Legat, Denis, 91090 Lisses (FR); Hermann, Peter, 91410 Corbreuse (FR); Allais Arnaud, 22600 Loudeac (FR); Duperray, Gérard, 91190 La Norville (FR); Beghin, Erik, 92100 Boulogne (FR)
(74) Mandataire: Fournier, Michel

(57) **Abrégé**

l'invention concerne un brin multifilamentaire à matrice (2) à base d'argent, comprenant une pluralité de filaments supraconducteurs HTc (3) ayant une section transversale de forme générale carrée ou rectangulaire, selon l'invention les filaments supraconducteurs HTc (3) sont arrangés en quinconce.

## Description

L'invention concerne un brin supraconducteur à Haute Température critique (HTc), une méthode de fabrication d'un tel brin, et une application supraconductrice pourvue d'un tel brin.

L'invention concerne plus particulièrement les brins supraconducteurs à Haute Température critique (HTc) fabriqués selon la méthode dite "poudre en tube" (Powder In Tube ou PIT).

La technique PIT est connue par elle même et consiste, dans une première étape, à densifier des précurseurs de supraconducteur HTc dans un tube metallique. Dans une seconde étape, la billette ainsi réalisée est déformée, par exemple par tréfilage, pour obtenir un brin dit monofilamentaire. Dans une troisième étape, ce brin monofilamentaire est tronçonné et arrangé dans une nouvelle enveloppe métallique formant ainsi une billette multifilamentaire. Cette nouvelle billette multifilamentaire est elle aussi déformée et mise en forme jusqu'à obtenir un brin multifilamentaire aux dimensions et à la forme voulues. Au cours de ces étapes de fabrication, et dans le but de transformer les précurseurs en phase supraconductrice HTc il est nécessaire d'effectuer plusieurs traitements thermiques de transformation et plusieurs laminages intermédiaires de réactivation des précurseurs. On sait que le matériau constitutif du tube ou de l'enveloppe doit être suffisamment ductile pour pouvoir subir les différentes phases d'étirages et de laminage, et avoir une composition inerte ou du moins sans conséquences pour le traitement thermique de transformation des précurseurs de supraconducteur HTc en phase supraconductrice. Il est connu d'utiliser l'Argent ou un alliage à base d'Argent comme matériau constitutif des billettes.

Certaines applications utilisant des brins multifilamentaires supraconducteurs HTc demandent des longueurs conséquentes continues (par exemple bobines supraconductrice). Cela nécessite des méthodes de fabrication qui permettent d'obtenir de grandes longueurs de brin où les performances électriques et mécaniques du brin sont maintenues sur toute la longueur (notamment la phase supraconductrice).

Une première méthode consiste à fabriquer un monofilament de section transversale hexagonale tronçonné et arrangé dans une enveloppe hexagonale à base d'argent. Les brins réalisés à partir de cette méthode d'étirage à filières hexagonales ont des interfaces métal/précurseurs qui sont défavorables à une bonne diffusion de l'oxygène nécessaire à la synthèse de la phase supraconductrice des précurseurs.

Une autre méthode consiste à utiliser un brin monofilamentaire de section transversale carrée ou rectangulaire tronçonnée. Les tronçons sont empilés les uns sur les autres en plusieurs colonnes juxtaposées dans une enveloppe carrée ou rectangulaire à base d'argent. Cette méthode, du fait du rapport de forme du monofilament permet une meilleure diffusion de l'oxygène nécessaire à la synthèse de la phase supraconductrice des précurseurs. En outre la forme rectangulaire est une structure qui se prête particulièrement bien au torsadage. Cependant le brin multifilamentaire résultant présente des irrégularités de densification dans le filament. Ces défauts de densification résultent d'un mauvais écoulement des enveloppes à base d'argent autour des coeurs supraconducteurs HTc.

Un but de la présente invention est de proposer un brin multifilamentaire du type à monofilament de section transversale carrée ou rectangulaire dans lequel la densification des précurseurs et l'homogénéité de la déformation du brin sont sensiblement augmentées.

A cet effet l'invention concerne un brin multifilamentaire à matrice à base d'argent, comprenant une pluralité de filaments supraconducteurs HTc ayant une section transversale de forme générale carrée ou rectangulaire, selon l'invention chaque couche de filaments est décalée par rapport à la couche suivante ou précédente formant un arrangement des filaments en quinconce.

Un autre but de la présente invention est de proposer un procédé de fabrication d'un tel brin multifilamentaire.

A cet effet l'invention concerne un procédé de fabrication d'un brin multifilamentaire supraconducteur HTc à matrice à base d'argent du type poudre en tube, dans lequel :
on réalise un monofilament de section carrée ou rectangulaire, ayant une gaine à base d'argent et un coeur de précurseurs de supraconducteur HTc ;
on tronçonne ledit monofilament et on arrange les tronçons résultant dans une enveloppe à base d'argent de section carrée ou rectangulaire, réalisant ainsi une billette multifilamentaire ;
on applique les traitements thermiques et mécaniques pour obtenir la transformation des précurseurs en phase supraconductrice HTc et la forme définitive du brin multifilamentaire ;
selon l'invention, lors de la réalisation de la billette multifilamentaire, on arrange les tronçons de monofilament couche par couche dans l'enveloppe, chaque couche étant décalée par rapport à la précédente, de manière à former un arrangement en quinconce des tronçons.

Dans un mode de réalisation, on comble les espaces, laissés par les décalages en début ou en fin de couche, par des barreaux à base d'argent.

Dans un autre mode de réalisation on comble les espaces, laissés par les décalages en début ou en fin de couche, par des tronçons de monofilament de section carrée ou rectangulaire, ayant une gaine à base d'argent et un coeur de précurseur de supraconducteur HTc, de section adaptée à la section des espaces.

Un autre but de la présente invention est de proposer un câble multibrin supraconducteur HTc comprenant au moins un brin multifilamentaire selon l'invention.

Les brins constitutifs du câble peuvent être torsadés entre eux.

Avantageusement les brins sont transposés.

Un autre but de la présente invention est de proposer une application supraconductrice comprenant au moins une bobine supraconductrice constituée d'au moins un brin selon la présente invention.

La solution proposée par la présente invention, reposant sur un arrangement décalé des filaments, permet, à la fois de transmettre l'effort des traitements mécaniques, notamment les laminages, sur les filaments et de canaliser l'écoulement longitudinal de l'argent.

Les avantages résultant de la présente invention sont une densification homogène des filaments, un taux de déformation supérieure de la phase supraconductrice, un écoulement homogène de l'argent réduisant les variations de section du brin, une maîtrise des grandes longueurs en diminuant le nombre de défaut pouvant provoquer des ruptures en cours de fabrication.

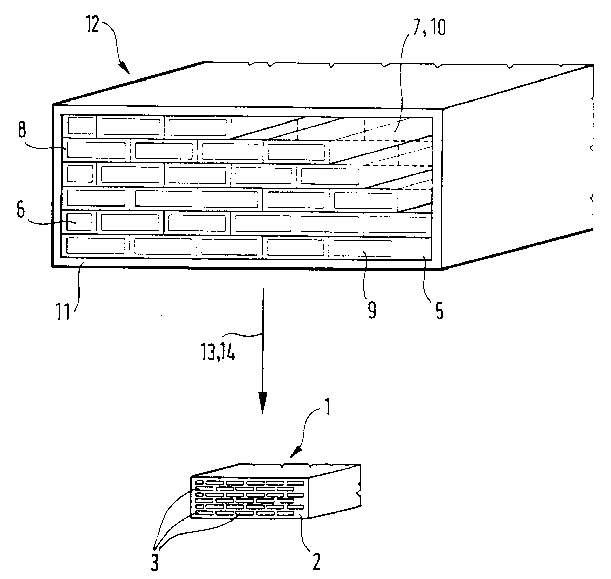

D'autres avantages et caractéristiques de la présente invention résulteront de la description qui va suivre en référence à la figure unique montrant une représentation schématique d'une billette multifilamentaire et d'un brin selon la présente invention.

L'invention concerne un brin multifilamentaire 1 à matrice 2 à base d'argent, comprenant une pluralité de filaments supraconducteurs HTc 3 ayant une section transversale de forme générale carrée ou rectangulaire, arrangés en couches. Chaque couche de filaments 3 est décalée par rapport à la couche suivante ou précédente formant un arrangement des filaments 3 en quinconce.

La présente invention concerne aussi un procédé de fabrication, du type poudre en tube, d'un brin multifilamentaire 1 supraconducteur HTc à matrice à base d'argent, dans lequel :
on réalise un monofilament 7 de section carrée ou rectangulaire, ayant une gaine 8 à base d'argent et un coeur 9 de précurseur de supraconducteur HTc ;
on tronçonne ledit monofilament 7 et on arrange les tronçons 10 résultant dans une enveloppe 11 à base d'argent de section carrée ou rectangulaire, réalisant ainsi une billette multifilamentaire 12 ;
on applique les traitements thermiques 13 et mécaniques 14 pour obtenir la transformation des précurseurs 9 en phase supraconductrice HTc 3 et la forme définitive du brin multifilamentaire 1 ;
selon l'invention, lors de la réalisation de la billette multifilamentaire 12, on arrange les tronçons de monofilament couche par couche dans l'enveloppe 11, chaque couche étant décalée par rapport à la précédente, de manière à former un arrangement en quinconce des tronçons 10.

Dans un mode de réalisation, on comble les espaces, laissés par les décalages en début ou en fin de couche, par des barreaux à base d'argent 5.

Dans un autre mode de réalisation on comble les espaces, laissés par les décalages en début ou en fin de couche, par des tronçons 6 de monofilament de section carrée ou rectangulaire, ayant une gaine à base d'argent et un coeur de précurseur de supraconducteur HTc, de section adaptée à la section des espaces.

L'invention concerne aussi un câble multibrin supraconducteur HTc comprenant au moins un brin multifilamentaire selon l'invention.

Le câble peut être torsadé. On pourra a cet effet se reporter au pocédé proposé dans FR9510764.

Avantageusement les brins sont transposés.

L'invention concerne enfin une application supraconductrice comprenant au moins une bobine supraconductrice constituée d'au moins un brin selon la présente invention. Ces applications peuvent être par exemple un moteur électrique, un transformateur, un câble d'énergie, ou toute autre application connue.

La solution proposée par la présente invention, reposant sur un arrangement décalé des filaments, permet, à la fois, de transmettre l'effort des traitements mécaniques, notamment les laminages, sur les filaments et de canaliser l'écoulement longitudinal de l'argent.

Les avantages résultant de la présente invention sont une densification homogène des filaments, un taux de déformation supérieur de la phase supraconductrice, un écoulement homogène de l'argent réduisant les variations de section du brin, une maîtrise des grandes longueurs en diminuant le nombre de défaut pouvant provoquer des ruptures en cours de fabrication.

Le matériau à base d'argent constituant les gaines, enveloppes, ou matrices peut être résistif pour permettre une bonne utilisation en régime alternatif (limitation du couplage entre filaments).

Bien entendu, l'invention n'est pas limitée au mode de réalisation décrit et représenté, mais elle est susceptible de nombreuses variantes accessibles à l'homme du métier sans que l'on s'écarte de l'invention. En particulier, on pourra, sans sortir du cadre de l'invention, augmenter le nombre de filaments supraconducteurs HTc dans le brin multifilamentaire, modifier le matériau à base d'argent pour qu'il réponde à des critères particuliers de fabrication ou d'utilisation.

## Revendications

1. Brin multifilamentaire à matrice (2) à base d'argent, comprenant une pluralité de filaments supraconducteurs HTc (3) sensiblement parallèles à l'axe longitudinal du brin, ayant une section transversale de forme générale carrée ou rectangulaire, caractérisé en ce que les filaments supraconducteurs HTc (3) sont arrangés en quinconce.

2. Procédé de fabrication du type poudre en tube d'un brin multifilamentaire (1) supraconducteur HTc à matrice (2) à base d'argent, dans lequel :
on fabrique un monofilament (7) de section carrée ou rectangulaire, ayant une gaine (8) à base d'argent et un coeur de précurseurs de supraconducteur HTc (9);
on tronçonne ledit monofilament (7) et on remplit une enveloppe (11) à base d'argent de section carrée ou rectangulaire avec les tronçons (10) résultants, réalisant ainsi une billette multifilamentaire (12);
on applique les traitements thermiques et mécaniques (13, 14) pour obtenir la transformation des précurseurs en phase supraconductrice HTc et la forme définitive du brin multifilamentaire (1);
caractérisé en ce que lors de la réalisation de la billette multifilamentaire (12), on arrange les tronçons (10) de monofilament couche par couche dans l'enveloppe (11), chaque couche étant décalée par rapport à la précédente, de manière à former un arrangement en quinconce des tronçons (10).

3. Procédé selon la revendication 2 caractérisé en ce qu'on comble les espaces, laissés par les décalages en début ou en fin de couche, par des barreaux (5) à base d'argent.

4. Procédé selon la revendication 2 caractérisé en ce qu'on comble les espaces, laissés par les décalages en début ou en fin de couche, par des tronçons (6) de monofilament de section carrée ou rectangulaire, ayant une gaine à base d'argent et un coeur de précurseur de supraconducteur HTc, et ayant une section adaptée à la section des espaces.

5. Câble multibrin supraconducteur HTc comprenant au moins un brin multifilamentaire (1) selon la revendication 1.

6. Câble selon la revendication 5 caractérisé en ce que le câble est torsadé.

7. Câble selon la revendication 5 ou 6 caractérisé en ce que les brins sont transposés.

8. Application supraconductrice comprenant au moins une bobine supraconductrice constituée d'au moins un brin multifilamentaire (1) selon la revendication 1.
